# EUROPEAN PATENT APPLICATION

(11) **EP 4 800 432 A1**
(43) Date of publication of application: **02.09.2026**
(21) Application number: 24882890.7
(22) Date of filing: 25.10.2024
(51) Int. Cl.: G01S 7/481, G02B 6/42, H01S 5/40

(54) **LIGHT OUTPUT DEVICE AND LIDAR DEVICE INCLUDING SAME**

(30) Priority: 27.10.2023 KR 20230145238
(71) Applicant: LG Innotek Co., Ltd., Seoul 07796 (KR)
(72) Inventor: PARK, Hye Mi, Seoul 07796 (KR); KIM, Tae Kyung, Seoul 07796 (KR); KIM, Dae Geun, Seoul 07796 (KR); KIM, Ho Young, Seoul 07796 (KR)
(74) Representative: Plasseraud IP
(86) International application number: PCT/KR2024/016384
(87) International publication number: WO 2025/089863

(57) **Abstract**

A LiDAR device according to an embodiment of the present invention includes a light-emitting unit configured to irradiate an optical signal to an object, and a light-receiving unit configured to receive an optical signal reflected from the object, and the light-emitting unit includes a light source, a first homogenizer lens spaced apart from the light source, and a second homogenizer lens spaced apart from the light source, and the first homogenizer lens and the second homogenizer lens each include a first surface disposed to face the light source and a second surface that is a surface opposite to the first surface, and the first surface of the first homogenizer lens includes a plurality of first convex patterns disposed to be adjacent to each other along a first direction, and the first surface of the second homogenizer lens includes a plurality of second convex patterns disposed to be adjacent to each other, and each of the second surface of the first homogenizer lens and the second surface of the second homogenizer lens is a flat surface, and the second homogenizer lens is tilted with respect to the second surface of the first homogenizer lens based on a virtual first axis in a third direction perpendicular to the first direction.

## Description

### [Technical Field]

The present invention relates to an optical output device and a LiDAR device including the same.

### [Background Art]

Light Detection and Ranging (LiDAR) uses a laser pulse which is emitted from a light-emitting unit and then reflected back by a target object to measure a distance to the target object or to create a shape of the target object. LiDAR is applied to various technical fields that require three-dimensional imaging. For example, LiDAR may be applied to technical fields such as meteorology, aviation, aerospace, and vehicles. Recently, LiDAR has become increasingly significant in the field of autonomous driving.

In general, a light-emitting unit of a LiDAR generates an output optical signal and irradiates it on an object, a light-receiving unit receives an input optical signal reflected from the object, and an information-generating unit generates information about the object using the input optical signal received by the light-receiving unit.

LiDAR may be broadly classified into mechanical LiDAR and solid-state LiDAR. The mechanical LiDAR may obtain a 360-degree field of view by rotating a light-emitting unit and a light-receiving unit. The solid-state LiDAR may be, for example, one of Micro Electro Mechanical System (MEMS) LiDAR, flash LiDAR, or Optical Phase Array (OPA) LiDAR. In MEMS LiDAR, a tilt angle of a mirror may be finely varied by an electric signal. In flash LiDAR, an optical flash is used, and a single large-area laser pulse may illuminate a forward environment. In OPA, an optical phase modulator controls a velocity of light passing through a lens, and accordingly a shape of an optical wavefront may be controlled.

When the light-emitting unit of the LiDAR includes a plurality of point light sources arranged in a one-dimensional array, the light-emitting unit of the LiDAR may include a homogenizer lens. The homogenizer lens may homogenize light output from a plurality of point light sources to generate a one-dimensional beam having a target FOV. However, according to a general one-dimensional array type homogenizer lens, FOV adjustment in a slow axis (SA) direction is easy, but beam width adjustment in a fast axis (FA) direction is not easy. To adjust the SA direction FOV and the FA direction beam width of the light-emitting unit to match the vertical FOV (VFOV) and horizontal FOV (HFOV) of the light-receiving unit lens, additional optical components or a two-dimensional shape homogenizer lens may be used, but this has a problem of increasing the manufacturing difficulty and cost of the LiDAR.

### [Disclosure]

### [Technical Problem]

A technical object to be achieved by the present invention is to provide an optical output device that simultaneously increases not only the SA direction FOV but also the FA direction beam width, and a LiDAR device including the same.

### [Technical Solution]

A LiDAR device according to an embodiment of the present invention includes a light-emitting unit configured to irradiate an optical signal to an object, and a light-receiving unit configured to receive an optical signal reflected from the object, and the light-emitting unit includes a light source, a first homogenizer lens spaced apart from the light source, and a second homogenizer lens spaced apart from the light source, and the first homogenizer lens and the second homogenizer lens each include a first surface disposed to face the light source and a second surface that is a surface opposite to the first surface, and the first surface of the first homogenizer lens includes a plurality of first convex patterns disposed to be adjacent to each other along a first direction, and the first surface of the second homogenizer lens includes a plurality of second convex patterns disposed to be adjacent to each other, and each of the second surface of the first homogenizer lens and the second surface of the second homogenizer lens is a flat surface, and the second homogenizer lens is tilted with respect to the second surface of the first homogenizer lens based on a virtual first axis in a third direction perpendicular to the first direction.

Each of the first convex patterns may extend along a second direction perpendicular to the first direction and the third direction.

The second homogenizer lens may be tilted by 1 degree or less in a clockwise direction or a counterclockwise direction using the third direction as a rotation axis.

The second homogenizer lens may be tilted by 0.4 degrees or more and 1 degree or less in a clockwise direction or a counterclockwise direction using the third direction as a rotation axis.

Each first convex pattern has a semi-cylindrical shape extending along the second direction, and a shape of each second convex pattern may be identical to a shape of each first convex pattern.

At least one of a material, refractive index, effective focal length, pitch, f-number, and curvature of each first convex pattern may be identical to at least one of a material, refractive index, effective focal length, pitch, f-number, and curvature of each second convex pattern.

An arrangement direction of the plurality of second convex patterns may have an angle of 0.4 degrees or more and 1 degree or less with the first direction.

Each first convex pattern extends along a second direction perpendicular to the first direction, and an extension direction of each second convex pattern may have an angle of 0.4 degrees or more and 1 degree or less with the second direction.

The light source includes a plurality of point light sources arranged along a first direction, and the plurality of first convex patterns may be disposed to be adjacent to each other along the first direction.

The plurality of point light sources may respectively correspond to the plurality of first convex patterns.

The light source may include an EEL (edge emitting laser).

The device may further include a condenser lens disposed between the light source and the first homogenizer lens.

The plurality of second convex patterns of the second homogenizer includes a 2-1 convex pattern and a 2-2 convex pattern spaced apart in the first direction, and a height of the 2-1 convex pattern and a height of the 2-2 convex pattern may be different.

The plurality of first convex patterns of the first homogenizer includes a 1-1 convex pattern and a 1-2 convex pattern spaced apart in the first direction, and a height of the 1-1 convex pattern and a height of the 1-2 convex pattern may be identical.

The height of the 2-1 convex pattern may be greater than the height of the 1-1 convex pattern, and the height of the 2-2 convex pattern may be smaller than the height of the 1-1 convex pattern.

An optical output device according to an embodiment of the present invention includes a light source, a first homogenizer lens spaced apart from the light source, and a second homogenizer lens spaced apart from the first homogenizer lens, and the first homogenizer lens and the second homogenizer lens each include a first surface disposed to face the light source and a second surface that is a surface opposite to the first surface, and the first surface of the first homogenizer lens includes a plurality of first convex patterns disposed to be adjacent to each other, and the first surface of the second homogenizer lens includes a plurality of second convex patterns disposed to be adjacent to each other, and each of the second surface of the first homogenizer lens and the second surface of the second homogenizer lens is a flat surface, and the first convex pattern extends along a first axis, and the second convex pattern extends along a second axis, and the second axis is tilted with respect to the first axis.

An optical output device according to another embodiment of the present invention includes a light source, a base spaced apart from the light source, a first homogenizer lens spaced apart from the light source and disposed on the base, and a second homogenizer lens spaced apart from the light source and disposed on the base, and a first surface of the first homogenizer lens includes a plurality of first convex patterns disposed to be adjacent to each other, and a first surface of the second homogenizer lens includes a plurality of second convex patterns disposed to be adjacent to each other, and the first convex pattern is formed to extend along a first axis from the base, and the second convex pattern is formed to extend along a second axis from the base, and the second axis is tilted with respect to the first axis.

### [Advantageous Effects]

According to an embodiment of the present invention, an optical output device and a LiDAR device including the same that simultaneously expand not only the SA direction FOV but also the FA direction beam width can be obtained. In particular, according to an embodiment of the present invention, since not only the SA direction FOV but also the FA direction beam width can be simultaneously expanded without additional optical components or a two-dimensional homogenizer lens, an object detection effect can be increased while minimizing an increase in manufacturing difficulty or cost.

### [Description of Drawings]

FIG. 1 is a block diagram of a LiDAR device according to an embodiment of the present invention.
FIG. 2 is a cross-sectional view of a light-receiving unit according to an embodiment of the present invention.
FIG. 3 is a top view of an image sensor according to an embodiment of the present invention.
FIG. 4 is a bottom view of a micro lens array according to an embodiment of the present invention.
FIG. 5(a) is a cross-sectional view of a light-emitting unit according to an embodiment of the present invention, and FIG. 5(b) is a top view of a light source included in a light-emitting unit according to an embodiment of the present invention.
FIG. 6 is a diagram for explaining a correspondence relationship between a light source, a condenser lens, a first homogenizer lens, and a second homogenizer lens of a light-emitting unit according to an embodiment of the present invention.
FIG. 7 is a perspective view of a first homogenizer lens and a second homogenizer lens of a light-emitting unit according to an embodiment of the present invention.
FIG. 8 is a cross-sectional view of a first homogenizer lens and a second homogenizer lens of a light-emitting unit according to an embodiment of the present invention.
FIG. 9 is a front view of a first homogenizer lens and a second homogenizer lens of a light-emitting unit according to an embodiment of the present invention.
FIG. 10(a) is a beam intensity profile before applying a homogenizer lens, FIG. 10(b) is a beam intensity profile in a case where a second homogenizer lens is not tilted in a state where a first homogenizer lens and a second homogenizer lens are disposed on a light source, and FIG. 10(c) is a beam intensity profile in a case where a second homogenizer lens is tilted by 0.55 degrees using a third direction as a rotation axis in a state where a first homogenizer lens and a second homogenizer lens are disposed on a light source.
FIG. 11 is a cross-sectional graph of a beam intensity profile in a case where a second homogenizer lens is not tilted and in a case where it is tilted by 0.55 degrees using a third direction as a rotation axis in a state where a first homogenizer lens and a second homogenizer lens are disposed on a light source.
FIG. 12(a) is a beam intensity profile in a case where a first homogenizer lens is tilted in a range of -0.8 degrees to 0.8 degrees, and FIG. 12(b) is a beam intensity profile in a case where a second homogenizer lens is tilted in a range of -0.8 degrees to 0.8 degrees.
FIG. 13(a) represents an FOV of a light-receiving unit lens in a long-range LiDAR, FIG. 13(b) is a beam profile in a case where a second homogenizer lens is not tilted in a long-range LiDAR, and FIG. 13(c) is a beam profile in a case where a second homogenizer lens is tilted in a long-range LiDAR.
FIG. 14(a) represents an FOV of a light-receiving unit lens in a mid-range LiDAR, FIG. 14(b) is a beam profile in a case where a second homogenizer lens is not tilted in a mid-range LiDAR, and FIG. 14(c) is a beam profile in a case where a second homogenizer lens is tilted in a mid-range LiDAR.
FIG. 15 is a perspective view of a LiDAR system according to an embodiment of the present invention.
FIG. 16 is an exploded view of a LiDAR system according to an embodiment of the present invention.
FIG. 17 is an exploded view of a LiDAR device according to an embodiment of the present invention.

### [Modes of the Invention]

Hereinafter, preferred embodiments of the present invention will be described in detail with reference to the accompanying drawings.

However, the technical spirit of the present invention is not limited to some embodiments to be described, but may be implemented in various different forms, and within the scope of the technical spirit of the present invention, one or more of the components between the embodiments may be selectively combined or substituted for use.

In addition, terms (including technical and scientific terms) used in embodiments of the present invention may be interpreted as meanings generally understood by those of ordinary knowledge in the technical field to which the present invention belongs, unless clearly specially defined and described, and generally used terms such as terms defined in a dictionary will be able to interpret their meanings in consideration of the contextual meaning of the related technology.

In addition, terms used in the embodiments of the present invention are for explaining the embodiments and are not intended to limit the present invention.

In this specification, a singular form may also include a plural form unless specifically mentioned in the phrase, and when described as "at least one (or one or more) of A and B, C", it may include one or more of all combinations that can be combined with A, B, and C.

In addition, in describing components of the embodiment of the present invention, terms such as first, second, A, B, (a), and (b) may be used.

These terms are only for distinguishing the component from other components, and are not limited to the essence, order, or sequence of the corresponding component by the term.

And, when a certain component is described as being 'connected', 'coupled', or 'joined' to another component, the component is not only directly connected, coupled, or joined to the other component, but also another component between the component and the other component may include the case of being 'connected', 'coupled', or 'joined' due to it.

In addition, when described as being formed or disposed on "top (above) or bottom (below)" of each component, top (above) or bottom (below) includes not only the case where two components directly contact each other but also the case where one or more other components are formed or disposed between two components. In addition, when expressed as "top (above) or bottom (below)", it may include the meaning of not only the upward direction but also the downward direction based on one component.

A LiDAR device according to an embodiment of the present invention may mean a LiDAR device that is mounted on a vehicle and measures a distance between the vehicle and an object, but is not limited thereto. A LiDAR device according to an embodiment of the present invention may extract depth information using a ToF (Time of Flight) principle or a phase shift principle. In this specification, a LiDAR device may also be referred to as an information generating device, a depth information generating device, or a camera device.

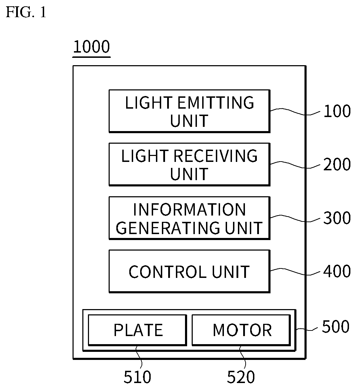

FIG. 1 is a block diagram of a LiDAR device according to an embodiment of the present invention.

Referring to FIG. 1, a LiDAR device (1000) according to an embodiment of the present invention includes a light emitting unit (100), a light receiving unit (200), an information generating unit (300), and a control unit (400).

The light emitting unit 100 may generate and output an output optical signal in the form of a pulse wave or a continuous wave. The continuous wave may be in the form of a sinusoid wave or a squared wave. By generating the output optical signal in the form of a pulse wave or a continuous wave, the LiDAR device 1000 can detect a time difference or a phase difference between the output optical signal output from the light emitting unit 100 and an input optical signal input to the light receiving unit 200 after being reflected from a target area. In the present specification, the output light refers to light that is output from the light emitting unit 100 and incident on an object, and the input light may refer to light that is output from the light emitting unit 100, reaches the target area, is reflected from the target area, and is input to the light receiving unit 200. From the perspective of the target area, the output light may be incident light, and the input light may be reflected light. In the present specification, the target area may be used interchangeably with an object or a body.

The light receiving unit 200 may receive an optical signal reflected from the target area. At this time, the received optical signal may be one in which the optical signal output by the light emitting unit 100 is reflected from the target area.

The light receiving unit 200 includes an image sensor, a lens group disposed on the image sensor, and a filter.

The optical signal reflected from the target area may pass through the lens group of the light receiving unit 200. An optical axis of the lens group of the light receiving unit 200 may be aligned with an optical axis of the image sensor. The filter may be disposed on an optical path between the target area and the image sensor. The filter may filter light having a predetermined wavelength range. The filter may pass light of a specific wavelength. For example, the filter may pass light in an infrared or near-infrared band and block light other than the infrared or near-infrared band. The image sensor receives the optical signal and may output the received optical signal as an electrical signal. The image sensor may sense light of a wavelength corresponding to the wavelength of the light output by the light emitting unit 100. For example, the image sensor may sense light in the infrared or near-infrared band.

The image sensor may be configured in a structure in which a plurality of pixels are arranged in a grid form.

The light receiving unit 200 and the light emitting unit 100 may be arranged side by side. The light receiving unit 200 may be disposed next to the light emitting unit 100. The light receiving unit 200 may be disposed to face the same direction as the light emitting unit 100. Alternatively, the light receiving unit 200 and the light emitting unit 100 may be disposed to face different directions. When the light receiving unit 200 and the light emitting unit 100 are disposed to face different directions, an optical path conversion member may be further disposed between the light receiving unit 200 and the light emitting unit 100.

The information generating unit 300 generates information regarding the target area by using the input optical signal input to the light receiving unit 200. The information regarding the target area may include 3D information regarding the target area. For example, the information regarding the target area may include depth information regarding the target area or shape information of the target area. For example, the information generating unit 300 may calculate depth information of the object by using a time of flight taken from when the output optical signal output from the light emitting unit 100 is reflected from the object until it is input to the light receiving unit 200. For example, the information generating unit 300 may calculate a time difference between the output optical signal and the input optical signal by using the electrical signal received by the image sensor, and calculate a distance between the target area and the LiDAR device 1000 by using the calculated time difference. For example, the information generating unit 300 may calculate a phase difference between the output optical signal and the input optical signal by using the electrical signal received from the image sensor, and calculate the distance between the target area and the LiDAR device 1000 by using the calculated phase difference.

The control unit 400 controls the driving of the light emitting unit 100, the light receiving unit 200, and the information generating unit 300. The information generating unit 300 and the control unit 400 may be implemented in the form of a printed circuit board (PCB). Alternatively, the information generating unit 300 and the control unit 400 may be implemented in the form of other configurations. Alternatively, the control unit 400 may be included in a terminal or a vehicle in which the LiDAR device 1000 according to the embodiment of the present invention is disposed. For example, the control unit 400 may be implemented in the form of an Application Processor (AP) of a smartphone equipped with the LiDAR device 1000 according to the embodiment of the present invention, or implemented in the form of an electronic control unit (ECU) of a vehicle equipped with the LiDAR device 1000 according to the embodiment of the present invention.

The LiDAR device 1000 according to the embodiment of the present invention may be a mechanical LiDAR that rotates 360°. To this end, the LiDAR device 1000 may further include a rotating unit 500. The rotating unit 500 may further include a plate 510 on which the light emitting unit 100 and the light receiving unit 200 are mounted, and a motor 520 that rotates the plate 510. According to this, the LiDAR device 1000 may have a FOV of 360°.

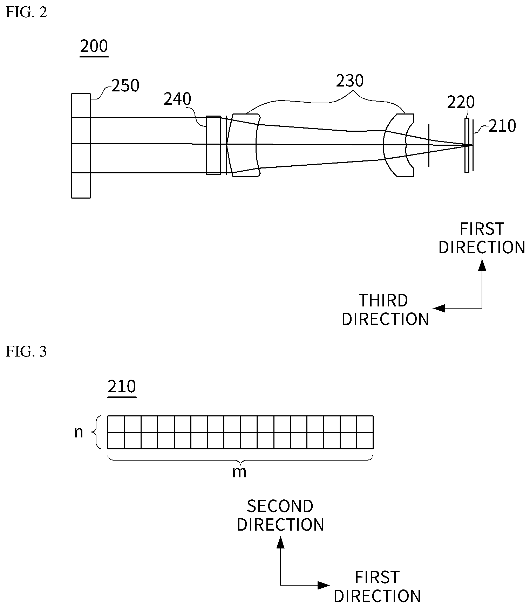

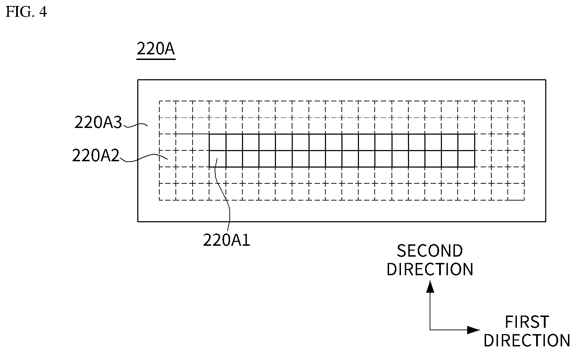

FIG. 2 is a cross-sectional view of a light receiving unit according to an embodiment of the present invention, FIG. 3 is a top view of an image sensor according to an embodiment of the present invention, and FIG. 4 is a bottom view of a micro lens array according to an embodiment of the present invention.

Referring to FIGS. 2 to 4, the light receiving unit 200 included in the LiDAR device 1000 according to the embodiment of the present invention includes an image sensor 210, a micro lens array 220 disposed on the image sensor 210, a lens group 230 disposed on the micro lens array 220, a filter 240 disposed on the lens group 230, and a window 250 disposed on the filter 240.

According to an embodiment of the present invention, the image sensor 210 includes a pixel array. Here, the pixel array may be a single photon avalanche detector (SPAD) array, and the SPAD array may include a plurality of SPADs. When the SPAD receives an optical signal, photons may be detected by an avalanche phenomenon.

Here, the image sensor 210 includes a pixel array arranged along a first direction and a second direction, and the number of pixels arranged along the first direction may be greater than the number of pixels arranged along the second direction. For example, the image sensor 210 according to the embodiment of the present invention includes an m*n pixel array, and m may be greater than n. When the ratio of m to n is 8 or more, it may be referred to as a 1D pixel array or a 1D SPAD array.

According to an embodiment of the present invention, the image sensor 210 may include a 1D pixel array. For example, the image sensor 210 according to the embodiment of the present invention may include a 16*2 pixel array, a 32*2 pixel array, a 64*2 pixel array, a 128*2 pixel array, a 256*2 pixel array, a 512*2 pixel array, or a 1024*2 pixel array.

According to an embodiment of the present invention, the micro lens array 220 is disposed on the image sensor 210 to be spaced apart from the image sensor 210. The micro lens array 220 includes a first surface 220A disposed to face the image sensor 210 and a second surface that is a surface opposite to the first surface 220A, and a plurality of micro lenses protrude from the first surface 220A toward the image sensor 210. For convenience of explanation, the first surface 220A of the micro lens array 220 is referred to as a bottom surface of the micro lens array 220, and the second surface of the micro lens array 220 may be referred to as a top surface of the micro lens array 220. According to an embodiment of the present invention, a plurality of micro lenses are formed on the first surface 220A of the micro lens array 220, and the second surface of the micro lens array 220 may be a flat surface.

The first surface 220A of the micro lens array 220 according to the embodiment of the present invention includes an effective region 220A1 including a plurality of micro lenses corresponding to the pixel array of the image sensor 210, a buffer region 220A2 including a plurality of micro lenses disposed to surround the effective region 220A1, and a peripheral region 220A3 disposed to surround the buffer region 220A2.

Here, the effective region 220A1 may be matched one-to-one with the pixel array. That is, when the image sensor 210 includes an m*n pixel array, the effective region 220A1 includes m*n micro lenses, and the pixels of the image sensor 210 and the micro lenses of the effective region 220A1 may be matched one-to-one. According to this, among the optical signals incident on the light receiving unit 200, the optical signal incident on the effective region 220A1 is sensed by the image sensor 210 and can be used to recognize an object. The optical signal incident on the light receiving unit 200 is condensed by the micro lenses of the effective region 220A1 of the micro lens array 220, so that light receiving efficiency for each pixel can be increased. Accordingly, the micro lens array 220 may also be referred to as a sensor window.

Meanwhile, the buffer region 220A2 may be disposed to surround the effective region 220A1 at the periphery of the effective region 220A1. For example, when the image sensor 210 includes an m*n pixel array and the effective region 220A1 includes m*n micro lenses, the first surface 220A of the micro lens array 220 may include a total of (m+2a)*(n+2b) micro lenses including the buffer region 220A2. Here, a and b may be the same or different. For example, a and b may each be 1 or more and 10 or less, preferably 1 or more and 5 or less, and more preferably 2 or more and 3 or less. For example, a may be 3 and b may be 2. In this way, when the first surface 220A of the micro lens array 220 includes the buffer region 220A2 surrounding the effective region 220A1, the light collection efficiency of the effective region 220A1 is improved and the loss of the optical signal can be reduced.

Meanwhile, the peripheral region 220A3 may be disposed to surround the buffer region 220A2 at the periphery of the buffer region 220A2. At this time, the peripheral region 220A3 may be a flat surface. According to this, the micro lens array 220 may be bonded to the image sensor 210 or a structure within the light receiving unit 200 through the peripheral region 220A3.

Referring to FIG. 2, the lens group 230, the filter 240, and the window 250 are sequentially disposed on the image sensor 210 and the micro lens array 220. Here, the lens group 230 may include a plurality of lenses. For example, the lens group 230 may include two lenses disposed to be spaced apart from each other, but is not limited thereto. The filter 240 disposed on the lens group 230 may be a bandpass filter. For example, it may be a bandpass filter that transmits only an IR optical signal among the optical signals input to the receiving unit 200. Although not shown, the lens group 230 and the filter 240 may be disposed in a lens barrel. Although the image sensor 210, the micro lens array 220, the lens group 230, and the filter 240 are shown as being sequentially disposed, the present invention is not limited thereto, and the image sensor 210, the micro lens array 220, the filter 240, and the lens group 230 may be disposed in that order.

The window 250 is disposed outside the lens barrel, and the optical signal reflected from the object passes through the window 250 and then is sequentially incident on the filter 240, the lens group 230, the micro lens array 220, and the image sensor 210. Accordingly, the window 250 may be referred to as a glass window or an external window. The optical signal output from the light emitting unit 100 may also be output to the outside through the window 250.

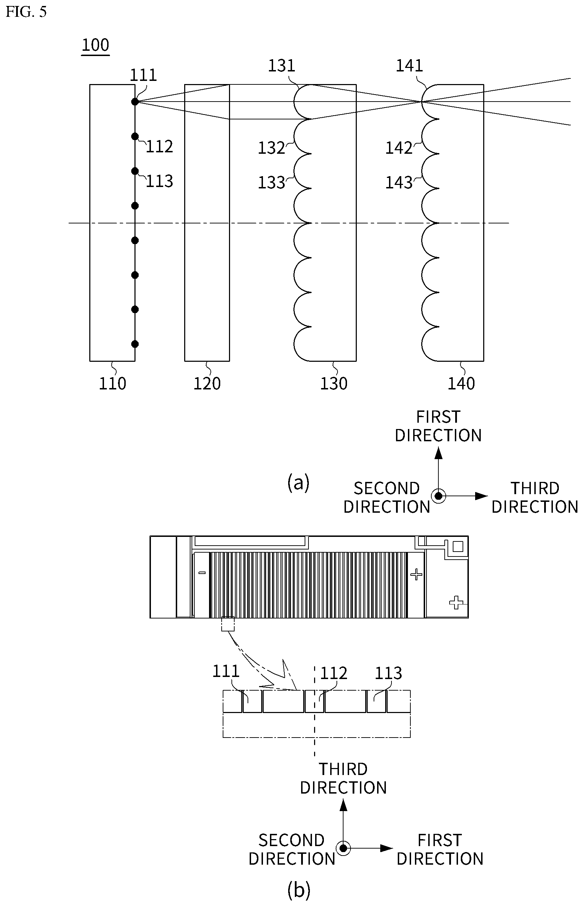

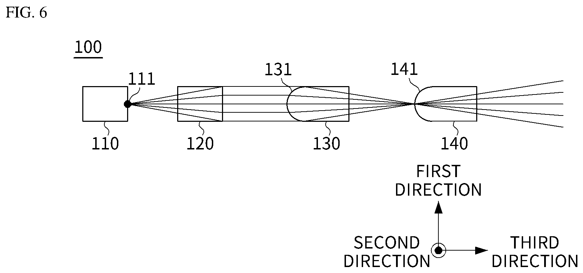

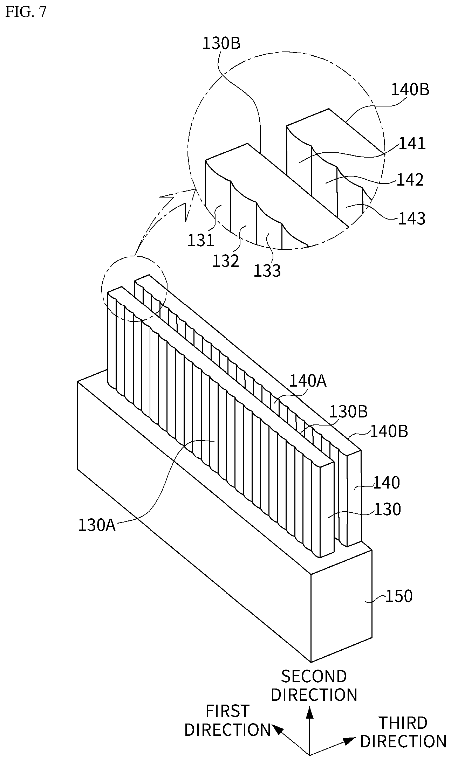

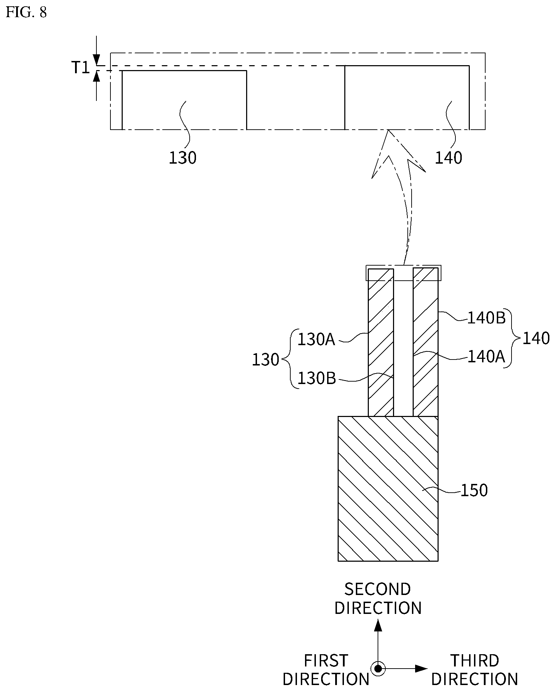

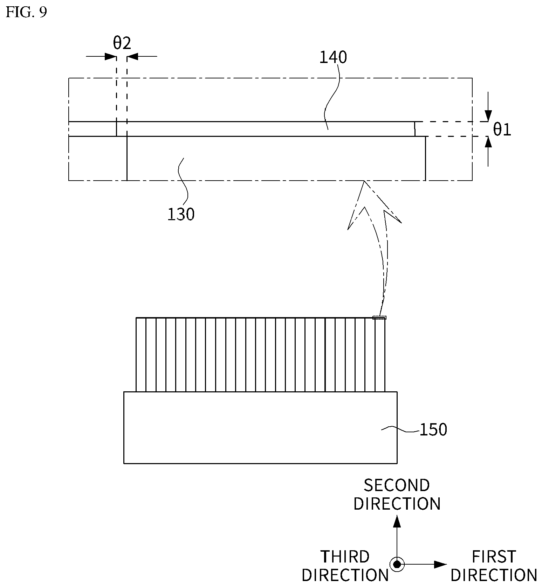

FIG. 5(a) is a cross-sectional view of a light emitting unit according to an embodiment of the present invention, FIG. 5(b) is a top view of a light source included in a light emitting unit according to an embodiment of the present invention, and FIG. 6 is a view for explaining a correspondence relationship between a light source, a condenser lens, a first homogenizer lens, and a second homogenizer lens of a light emitting unit according to an embodiment of the present invention, and FIG. 7 is a perspective view of a first homogenizer lens and a second homogenizer lens of a light emitting unit according to an embodiment of the present invention, FIG. 8 is a cross-sectional view of a first homogenizer lens and a second homogenizer lens of a light emitting unit according to an embodiment of the present invention, and FIG. 9 is a front view of a first homogenizer lens and a second homogenizer lens of a light emitting unit according to an embodiment of the present invention.

Referring to FIGS. 5(a), 5(b), and 6, the light emitting unit 100 includes a light source 110, a condenser lens 120, a first homogenizer lens 130, and a second homogenizer lens 140.

The light source 110 generates and outputs a laser pulse. The light source may use a light emitting diode (LED), and may have a form in which a plurality of light emitting diodes are arranged according to a certain pattern. Alternatively, the light source may include an organic light emitting diode (OLED) or a laser diode (LD). Alternatively, the light source may be a vertical cavity surface emitting laser (VCSEL). The VCSEL is one of the laser diodes that converts an electrical signal into an optical signal, and can output a wavelength of about 800 to 1000 nm, for example, about 850 nm or about 940 nm. Alternatively, the light source may output short wavelength infrared (SWIR). The SWIR may mean a wavelength of 900 nm to 2500 nm, for example, a wavelength of about 1430 nm. The light source repeats on/off at regular time intervals to generate an output optical signal in the form of a pulse wave or a continuous wave. The regular time interval may be a frequency of the output optical signal. Alternatively, the light source may include an edge emitting laser (EEL). According to this, the spectral width of the laser is reduced, and the wavelength change according to temperature can be suppressed.

According to an embodiment of the present invention, as shown in FIGS. 5(a) and 5(b), the light source 110 may include a plurality of point light sources in a 1D array shape. For example, the light source 110 may include a plurality of point light sources 111, 112, and 113 regularly arranged along a first direction. As shown in FIG. 5(b), a plurality of light sources 110 are regularly arranged along the first direction and extend along a third direction perpendicular to the first direction, and light emitted from the light source 110 may be output along the third direction. In this way, the light source 110 may be an edge emitting laser (EEL).

According to an embodiment of the present invention, the condenser lens 120 condenses light output from each point light source, converts it into parallel light, and outputs it. To this end, the condenser lens 120 may be disposed above the light source 110 to be spaced apart from the light source 110. Here, the upper part of the light source 110 may mean a side from which light is output from the light source 110. The condenser lens 120 may be at least one, and when there are a plurality of condenser lenses 120, the plurality of condenser lenses may form an optical system by aligning based on a central axis. Here, the central axis may be the same as an optical axis of the optical system.

According to an embodiment of the present invention, the first homogenizer lens 130 and the second homogenizer lens 140 homogenize and output light that has become parallel light by the condenser lens 120. To this end, the first homogenizer lens 130 is disposed above the light source 110 to be spaced apart from the light source 110, and the second homogenizer lens 140 is disposed to be spaced apart from the light source 110 with the first homogenizer lens 130 interposed therebetween. That is, the light source 110, the condenser lens 120, the first homogenizer lens 130, and the second homogenizer lens 140 are sequentially arranged to be spaced apart from each other. The first homogenizer lens 130 and the second homogenizer lens 140 each include a plurality of convex patterns, and each point light source included in the light source 110 may correspond to each convex pattern included in the first homogenizer lens 130 and the second homogenizer lens 140.

For example, light output from the first point light source 111 is converted into parallel light through the condenser lens 120, and then is incident on the first convex pattern 131 of the first homogenizer lens 130, and the light passing through the first convex pattern 131 of the first homogenizer lens 130 is incident on the first convex pattern 141 of the second homogenizer lens 140 and then can be homogenized and output. At this time, the distance between the first homogenizer lens 130 and the second homogenizer lens 140 may be set such that a focal plane of the light passing through the first convex pattern 131 of the first homogenizer lens 130 becomes the first convex pattern 141 of the second homogenizer lens 140.

Referring to FIGS. 7 and 8, the first homogenizer lens 130 and the second homogenizer lens 140 include first surfaces 130A and 140A disposed to face the light source 110 and second surfaces 130B and 140B which are opposite surfaces of the first surfaces 130A and 140A, respectively. The first homogenizer lens 130 and the second homogenizer lens 140 are disposed on a base 150. The base 150 is spaced apart from the light source 110. Both the first homogenizer lens 130 and the second homogenizer lens 140 may be disposed on one base 150. For example, the first homogenizer lens 130 and the second homogenizer lens 140 may be disposed to be spaced apart from each other on the top surface of the base 150.

According to an embodiment of the present invention, the first surface 130A of the first homogenizer lens 130 includes a plurality of first convex patterns 131, 132, 133 disposed to be adjacent to each other, and the first surface 140A of the second homogenizer lens 140 includes a plurality of second convex patterns 141, 142, 143 disposed to be adjacent to each other, and the second surface 130B of the first homogenizer lens 130 and the second surface 140B of the second homogenizer lens 140 are flat surfaces.

When the light source 110 includes a plurality of point light sources regularly arranged along a first direction, the plurality of first convex patterns 131, 132, 133 of the first surface 130A of the first homogenizer lens 130 may be arranged to be adjacent to each other along the first direction. As described above, each point light source may be arranged to correspond to each first convex pattern. According to an embodiment of the present invention, each of the plurality of first convex patterns 131, 132, 133 may extend along a second direction perpendicular to the first direction. That is, each of the plurality of first convex patterns 131, 132, 133 may extend to have a long axis in the second direction. For example, each of the plurality of first convex patterns 131, 132, 133 may be in the shape of a semi-circular cylinder extending in the second direction. That is, each of the plurality of first convex patterns 131, 132, 133 extends along a first axis in the second direction from the top surface of the base 150. Similarly, the plurality of second convex patterns 141, 142, 143 of the first surface 130A of the second homogenizer lens 140 have the same shape as the plurality of first convex patterns 131, 132, 133 of the first surface 130A of the first homogenizer lens 130, and correspond one-to-one with the plurality of first convex patterns 131, 132, 133 of the first surface 130A of the first homogenizer lens 130.

According to an embodiment of the present invention, at least one of a material, a refractive index, an effective focal length, a pitch, a f-number, and a curvature of each first convex pattern may be the same as at least one of a material, a refractive index, an effective focal length, a pitch, a f-number, and a curvature of each second convex pattern. According to an embodiment of the present invention, the pitch and the curvature of each first convex pattern may be the same as the pitch and the curvature of each second convex pattern. Here, the pitch may mean a width of each first convex pattern in the first direction.

Meanwhile, when the homogenizer lens includes a plurality of convex patterns and the plurality of convex patterns are arranged to be adjacent to each other along the first direction, the homogenizer lens can expand a FOV in the first direction. According to an embodiment of the present invention, it is intended to provide a structure that simultaneously expands not only the FOV in the first direction but also a FOV in the second direction without additional optical components or the design of a 2D homogenizer lens. In the present specification, the FOV in the first direction may be used interchangeably with the FOV in a short axis (SA) direction, and may correspond to a VFOV of a receiving unit lens. And, the FOV in the second direction may be used interchangeably with a beam width in the second direction or the beam width in a fast axis (FA) direction, and may correspond to a HFOV of the receiving unit lens.

Referring to FIGS. 8 and 9, the second homogenizer lens 140 is disposed to be tilted with respect to the first homogenizer lens 130 while the second surface 130B of the first homogenizer lens 130 and the second surface 140B of the second homogenizer lens 140 are parallel to each other.

According to an embodiment of the present invention, the second homogenizer lens 140 is tilted based on an imaginary axis in a third direction perpendicular to the first direction and the second direction. Here, being tilted based on the imaginary axis in the third direction may mean that an arrangement direction of the plurality of convex patterns 141, 142, 143 of the second homogenizer lens 140 is tilted to form a predetermined angle (θ1) with the first direction, which is an arrangement direction of the plurality of convex patterns 131, 132, 133 of the first homogenizer lens 130, or an extension direction of each convex pattern of the second homogenizer lens 140 is tilted to form a predetermined angle (θ2) with the second direction, which is an extension direction of each convex pattern of the first homogenizer lens 130. Hereinafter, for brevity, it may be expressed that the second homogenizer lens 140 is tilted with the third direction as a rotation axis.

That is, in a state where the second homogenizer lens 140 is not tilted, the arrangement direction of the plurality of second convex patterns 141, 142, 143 included in the second homogenizer lens 140 is the same as the first direction, which is the arrangement direction of the plurality of first convex patterns 131, 132, 133 included in the first homogenizer lens 130, and the extension direction of the plurality of second convex patterns 141, 142, 143 included in the second homogenizer lens 140 may be the same as the second direction, which is the extension direction of the plurality of first convex patterns 131, 132, 133 included in the first homogenizer lens 130. Accordingly, a height difference will not occur in the cross-sections of the first homogenizer lens 130 and the second homogenizer lens 140.

However, when the second homogenizer lens 140 is tilted based on an imaginary axis in the third direction according to an embodiment of the present invention, the arrangement direction of the plurality of second convex patterns 141, 142, 143 included in the second homogenizer lens 140 may form a predetermined angle (θ1) with the first direction, which is the arrangement direction of the plurality of first convex patterns 131, 132, 133 included in the first homogenizer lens 130. Similarly, when the second homogenizer lens 140 is tilted based on an imaginary axis in the third direction according to an embodiment of the present invention, the extension direction of the plurality of second convex patterns 141, 142, 143 included in the second homogenizer lens 140 may form a predetermined angle (θ2) with the second direction, which is the extension direction of the plurality of first convex patterns 131, 132, 133 included in the first homogenizer lens 130. Accordingly, as shown in the enlarged view of the cross-sectional view of FIG. 8, there may be a region where a height difference (T1) between the first homogenizer lens 130 and the second homogenizer lens 140 occurs.

In this way, when the second homogenizer lens 140 is tilted based on an imaginary axis in the third direction, in a case where the first convex patterns 131, 132, 133 of the first homogenizer lens 130 are formed to extend along a first axis from a top surface of the base 150, the second convex patterns 141, 142, 143 of the second homogenizer lens 140 are formed to extend along a second axis from the top surface of the base 150, and the second axis is tilted with respect to the first axis.

According to this, heights of the plurality of first convex patterns of the first homogenizer lens 130 are all the same, and heights of at least some of the plurality of second convex patterns of the second homogenizer lens 140 may be different from each other. Here, the height may mean a maximum height based on the top surface of the base 150. For example, when the first homogenizer lens 130 includes a 1-1 convex pattern and a 1-2 convex pattern spaced apart in the first direction, the height of the 1-1 convex pattern and the height of the 1-2 convex pattern may be the same. On the contrary, when the second homogenizer lens 140 includes a 2-1 convex pattern and a 2-2 convex pattern spaced apart in the first direction, the height of the 2-1 convex pattern and the height of the 2-2 convex pattern may be different from each other. For example, the height of the 2-1 convex pattern may be greater than the height of the 1-1 convex pattern or the height of the 1-2 convex pattern, and the height of the 2-2 convex pattern may be smaller than the height of the 1-1 convex pattern or the height of the 1-2 convex pattern.

In this way, when the second homogenizer lens 140 is tilted with the third direction as a rotation axis, not only the FOV in the first direction but also the beam width in the second direction can be simultaneously expanded without additional optical components or the design of a 2D homogenizer lens.

According to an embodiment of the present invention, the second homogenizer lens 140 may be tilted clockwise or counterclockwise with the third direction as a rotation axis by 1 degree or less, preferably 0.4 degrees or more and 1 degree or less. In FIG. 9, it is taken as an example that the second homogenizer lens 140 is tilted counterclockwise with the third direction as a rotation axis, but it may also be tilted clockwise. That is, the arrangement direction of the plurality of second convex patterns 141, 142, 143 included in the second homogenizer lens 140 may form an angle of 1 degree or less, preferably 0.4 degrees or more and 1 degree or less, with the first direction, which is the arrangement direction of the plurality of first convex patterns 131, 132, 133 included in the first homogenizer lens 130. Similarly, the extension direction of the plurality of second convex patterns 141, 142, 143 included in the second homogenizer lens 140 may form an angle of 1 degree or less, preferably 0.4 degrees or more and 1 degree or less, with the second direction, which is the extension direction of the plurality of first convex patterns 131, 132, 133 included in the first homogenizer lens 130. When the second homogenizer lens 140 is tilted at such an angle with the third direction as a rotation axis, not only the FOV in the first direction but also the beam width in the second direction can be simultaneously expanded without additional optical components or the design of a 2D homogenizer lens.

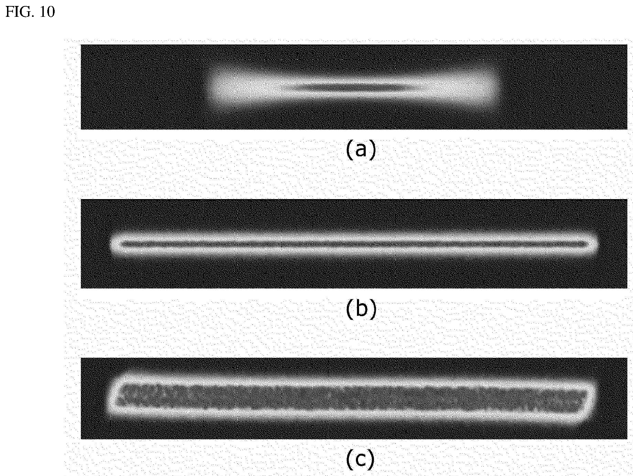

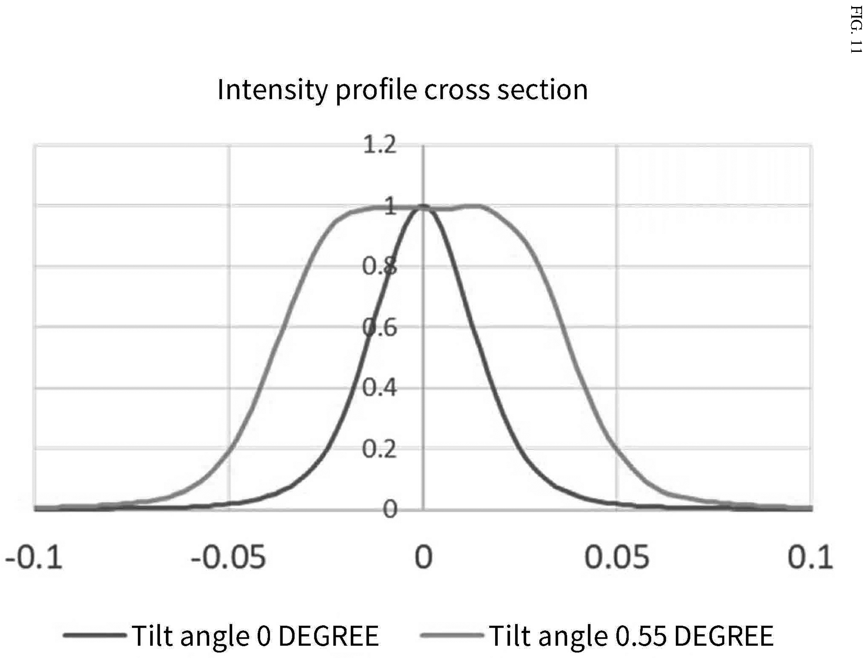

FIG. 10(a) is a beam intensity profile before applying a homogenizer lens, FIG. 10(b) is a beam intensity profile in a case where the second homogenizer lens is not tilted in a state where the first homogenizer lens and the second homogenizer lens are disposed on the light source, FIG. 10(c) is a beam intensity profile in a case where the second homogenizer lens is tilted by 0.55 degrees with the third direction as a rotation axis in a state where the first homogenizer lens and the second homogenizer lens are disposed on the light source, and FIG. 11 is a cross-sectional graph of the beam intensity profile in the second direction in the case where the second homogenizer lens is not tilted and the case where it is tilted by 0.55 degrees with the third direction as a rotation axis in a state where the first homogenizer lens and the second homogenizer lens are disposed on the light source.

Referring to FIGS. 10 to 11, it can be seen that the FOV in the first direction is expanded by the homogenizer lens, and in particular, it can be seen that the beam width in the second direction is also expanded when the second homogenizer lens is tilted. For example, when the second homogenizer lens is not tilted, the beam width in the second direction is 0.06 degrees, but when the second homogenizer lens is tilted by 0.55 degrees with the third direction as a rotation axis, it can be seen that the beam width in the second direction increases to 0.11 degrees.

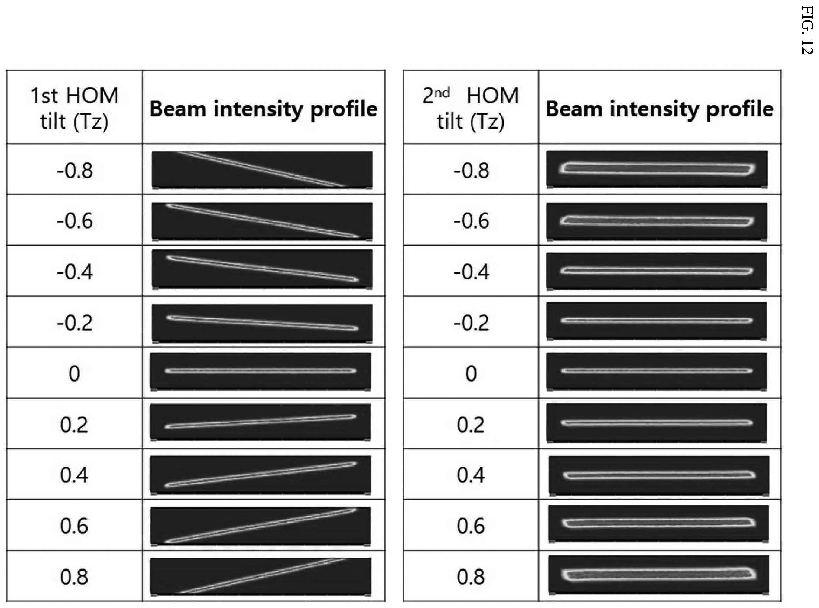

FIG. 12(a) is a beam intensity profile in a case where the first homogenizer lens is tilted in a range of -0.8 degrees to 0.8 degrees, and FIG. 12(b) is a beam intensity profile in a case where the second homogenizer lens is tilted in a range of -0.8 degrees to 0.8 degrees.

Referring to FIG. 12(a), it can be seen that when the first homogenizer lens is tilted, the beam intensity profile is also tilted together, but the beam width does not increase.

On the contrary, referring to FIG. 12(b), it can be seen that when the second homogenizer lens is tilted, the beam width in the second direction increases. In particular, it can be seen that the beam width in the second direction increases more as the tilt angle of the second homogenizer lens becomes larger.

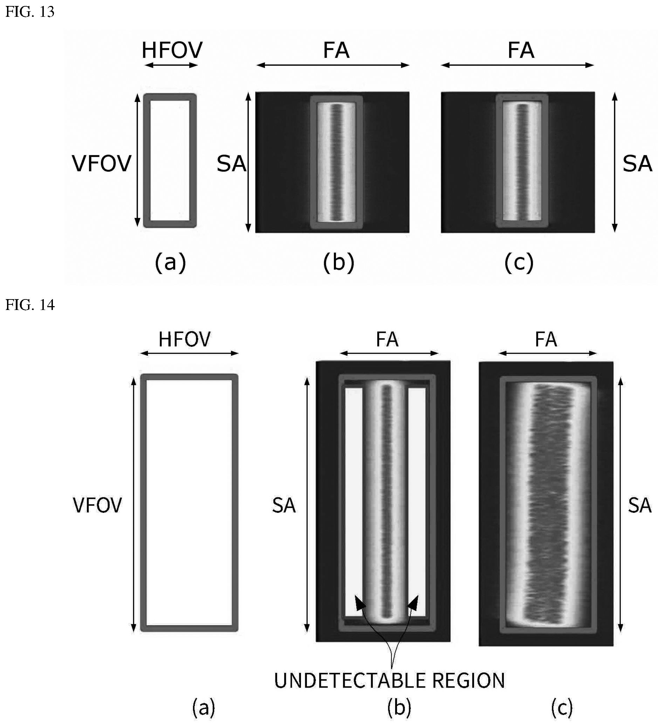

FIG. 13(a) shows the FOV of a receiving unit lens in a long-range LiDAR, FIG. 13(b) is a beam profile in a case where the second homogenizer lens is not tilted in the long-range LiDAR, FIG. 13(c) is a beam profile in a case where the second homogenizer lens is tilted in the long-range LiDAR, FIG. 14(a) shows the FOV of a receiving unit lens in a medium-range LiDAR, FIG. 14(b) is a beam profile in a case where the second homogenizer lens is not tilted in the medium-range LiDAR, and FIG. 14(c) is a beam profile in a case where the second homogenizer lens is tilted in the medium-range LiDAR.

Table 1 shows specifications of the first homogenizer lens and the second homogenizer lens used in a simulation for a long-range LiDAR, Table 2 shows specifications of the first homogenizer lens and the second homogenizer lens used in a simulation for a medium-range LiDAR, and Table 3 shows simulation results of the long-range LiDAR and the medium-range LiDAR.

**[Table 1]**

| FOV(SA direction) | 10° |
|---|---|
| Material | S-TIH53(Ohara) |
| Refractive index(@ 1430nm) | 1.8021 |
| EFL(@1430) | 4.816 |
| Thickness | 2 |
| NA(numerical aperture) | 0.095 |
| Lens gap | 5.7 |
| Pitch | 0.915 |
| SA FOI(calculated value, deg) | 10.9 |
| Fno. | 5.26 |
| Pitch(calculation) | 0.915 |
| Lens curvature R | 3.8629 |
| SA FOI(simulation, deg) | 11 |
| Lens gap(simulation) | 5.7062 |

**[Table 2]**

| FOV(SA direction) | 30° |
|---|---|
| Material | S-TIH53(Ohara) |
| Refractive index(@ 1430nm) | 1.8021 |
| EFL(@1430) | 1.345 |
| Thickness | 1 |
| NA(numerical aperture) | 0.3 |
| Lens gap | 1.79 |
| Pitch | 0.8 |
| SA FOI(calculated value, deg) | 34.6 |
| Fno. | 1.68 |
| Pitch(calculation) | 0.807 |
| Lens curvature R | 1.0788 |
| SA FOI(simulation, deg) | 34.1 |
| Lens gap(simulation) | 1.7901 |

**[Table 3]**

| | Rx | | 2nd HOM lens tilt 0° | | 2nd HOM lens tilt 0.55° | |
|---|---|---|---|---|---|---|
| | VFOV | HFOV | SA FOV | Beam width | SA FOV | Beam width |
| Long-range | 10 | 0.04 | 11 | 0.06 | 11 | 0.06 |
| Medium- | 30 | 0.12 | 34 | 0.06 | 34 | 0.11 |
| range | | | | | | |

Referring to FIGS. 13 to 14 and Tables 1 to 3, it can be seen that in the medium-range LiDAR, when the second homogenizer lens is not tilted, the beam width of the light emitting unit is narrower than the HFOV of the light receiving unit, and thus an undetectable region may exist. In contrast, it can be seen that when the second homogenizer lens is tilted according to the embodiment of the present invention in the medium-range LiDAR, the beam width of the light emitting unit is expanded to match a HFOV of the light receiving unit.

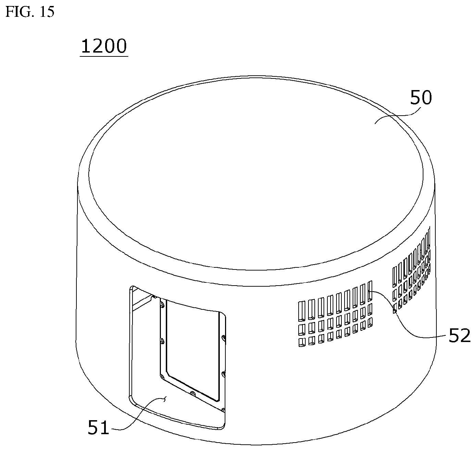

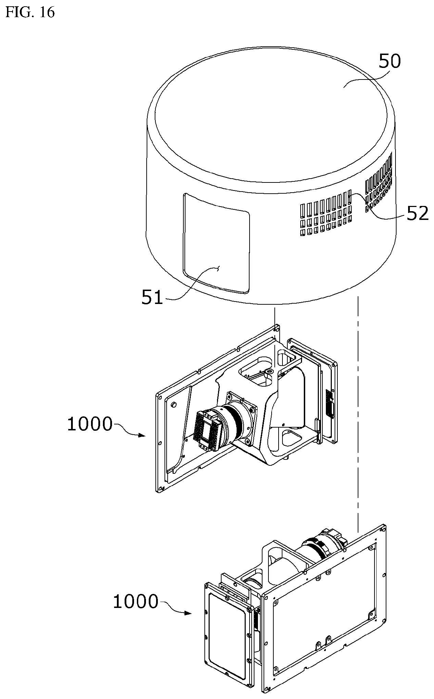

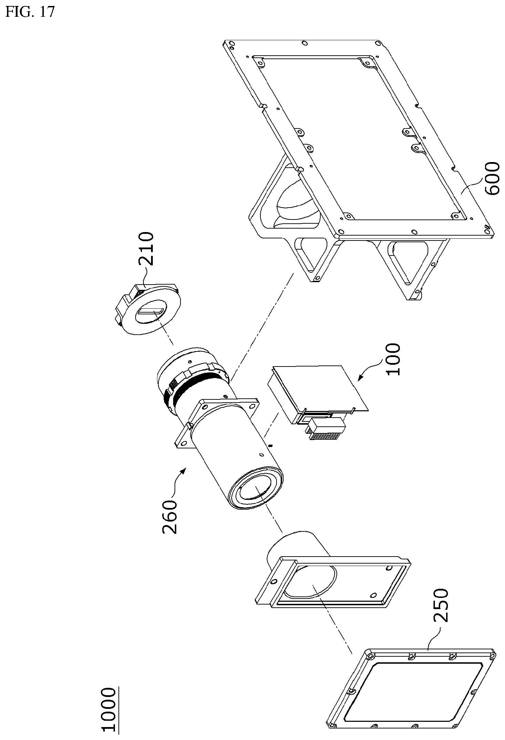

FIG. 15 is a perspective view of a LiDAR system according to an embodiment of the present invention, FIG. 16 is an exploded view of a LiDAR system according to an embodiment of the present invention, and FIG. 17 is an exploded view of a LiDAR device according to an embodiment of the present invention.

Referring to FIGS. 15 to 17, the light emitting unit 100 and the light receiving unit 200 may be accommodated within a housing 50 of a LiDAR system 1200. As shown, one LiDAR system 1200 may include a plurality of LiDAR devices 1000. For example, each LiDAR device 1000 included in one LiDAR system 1200 includes the light emitting unit 100 and the light receiving unit 200, and two LiDAR devices 1000 may be arranged to face opposite directions. One of the two LiDAR devices may be a medium-range LiDAR device, and the other may be a long-range LiDAR device.

A plurality of openings may be formed in the housing 50. A first opening 51 among the plurality of openings is disposed to correspond to the window 250 of the LiDAR device 1000 and may serve as a passage for light emission and reception. A second opening 52 among the plurality of openings may serve as a passage for discharging heat generated from the LiDAR device 1000 accommodated within the housing 50.

The number of the first openings 51 may be fewer than the number of the second openings 52, and a diameter of the first opening 51 may be larger than a diameter of the second opening 52. Since the first opening 51 is disposed to correspond to the window 250 of the LiDAR device 1000, the number of the first openings 51 formed in the housing 50 may be the same as the number of the LiDAR devices 1000 accommodated in the housing 50.

Each LiDAR device 1000 includes a light emitting unit 100 and a light receiving unit 200, and for this purpose, each LiDAR device 1000 may further include a mount 600 on which the light emitting unit 100 and the light receiving unit 200 are mounted. The light emitting unit 100 is disposed on a side of the light receiving unit 200, and both the light emitted from the light emitting unit 100 and the light incident on the light receiving unit 200 after being reflected from an object may pass through the window 250.

Although not specifically shown, the light emitting unit 100 may include a substrate, a light source, an optical member, a shield member, and a diffusion member. The substrate may include a printed circuit board (PCB). The substrate may also be connected to a connector through an FPCB. The light source is disposed on the substrate, and the substrate may include terminals. The light source may correspond to the light source 110 of the light emitting unit 100 described above. That is, the light source may include a plurality of emitters arranged in an array shape. The driving of the plurality of emitters may be controlled individually or integrally. Alternatively, the light source may be an edge emitting laser diode (EEL). The optical member may condense the light emitted from the light source or convert an optical path of the light emitted from the light source. For example, when the light source is not disposed to face the window 250, the optical member may convert the optical path so that the light emitted from the light source is emitted through the window 250. The optical member may correspond to the condenser lens 120 of the light emitting unit 100 described above. The shield member surrounds the substrate and the light source, may be referred to as a cover can, and may be a non-magnetic material, thereby blocking electromagnetic interference (EMI). The diffusion member may be a diffuser lens or a homogenizer. The diffusion member may be disposed on the optical path of the light emitted from the light source. The diffusion member may correspond to the first and second homogenizer lenses 130 and 140 of the light emitting unit 100 described above.

The light receiving unit 200 may include a sensor unit and a lens unit. The sensor unit may include a substrate, the image sensor 210 disposed on the substrate, and the micro lens array disposed on the image sensor 210. The image sensor 210 can sense infrared or near-infrared rays. The image sensor 210 can sense light of a specific wavelength among infrared or near-infrared rays. The lens unit may include a lens barrel, a plurality of lenses, a filter, and a lens hood. The image sensor 210 can sense the light that has passed through the filter. The image sensor 210 can sense light in the wavelength band of the light source. Through this, the image sensor 210 senses the light emitted from the light source and reflected by the subject, so that 3D image information of the subject can be sensed.

As described above, the LiDAR device according to the embodiment of the present invention may be a mechanical LiDAR device. Accordingly, the LiDAR device according to the embodiment of the present invention can be designed to rotate 360 degrees by a motor.

The above description has focused on the embodiments, but this is merely an example and does not limit the present invention. Those of ordinary skill in the art to which the present invention pertains will understand that various modifications and applications not illustrated above are possible without departing from the essential characteristics of the present embodiment. For example, each component specifically shown in the embodiments can be implemented with modifications. And differences related to such modifications and applications should be interpreted as being included in the scope of the present invention defined in the attached claims.

## Claims

1. A LiDAR device comprising:
a light-emitting unit configured to irradiate an optical signal to an object; and
a light-receiving unit configured to receive an optical signal reflected from the object,
wherein the light-emitting unit includes:
a light source;
a first homogenizer lens spaced apart from the light source; and
a second homogenizer lens spaced apart from the light source,
wherein the first homogenizer lens and the second homogenizer lens each include a first surface disposed to face the light source and a second surface that is a surface opposite to the first surface,
wherein the first surface of the first homogenizer lens includes a plurality of first convex patterns disposed to be adjacent to each other along a first direction,
wherein the first surface of the second homogenizer lens includes a plurality of second convex patterns disposed to be adjacent to each other,
wherein each of the second surface of the first homogenizer lens and the second surface of the second homogenizer lens is a flat surface, and
wherein the second homogenizer lens is tilted with respect to the second surface of the first homogenizer lens based on a virtual first axis in a third direction perpendicular to the first direction.

2. The LiDAR device of claim 1,
wherein each of the first convex patterns extends along a second direction perpendicular to the first direction and the third direction.

3. The LiDAR device of claim 2,
wherein the second homogenizer lens is tilted by 1 degree or less in a clockwise direction or a counterclockwise direction using the third direction as a rotation axis.

4. The LiDAR device of claim 3,
wherein the second homogenizer lens is tilted by 0.4 degrees or more and 1 degree or less in a clockwise direction or a counterclockwise direction using the third direction as a rotation axis.

5. The LiDAR device of claim 2,
wherein each first convex pattern has a semi-cylindrical shape extending along the second direction, and a shape of each second convex pattern is identical to a shape of each first convex pattern.

6. The LiDAR device of claim 5,
wherein at least one of a material, refractive index, effective focal length, pitch, f-number, and curvature of each first convex pattern is identical to at least one of a material, refractive index, effective focal length, pitch, f-number, and curvature of each second convex pattern.

7. The LiDAR device of claim 1,
wherein an arrangement direction of the plurality of second convex patterns has an angle of 0.4 degrees or more and 1 degree or less with the first direction.

8. The LiDAR device of claim 7,
wherein each first convex pattern extends along a second direction perpendicular to the first direction, and
wherein an extension direction of each second convex pattern has an angle of 0.4 degrees or more and 1 degree or less with the second direction.

9. The LiDAR device of claim 1,
wherein the light source includes a plurality of point light sources arranged along a first direction, and
wherein the plurality of first convex patterns are disposed to be adjacent to each other along the first direction.

10. The LiDAR device of claim 9,
wherein the plurality of point light sources respectively correspond to the plurality of first convex patterns.
